# EUROPEAN PATENT APPLICATION

(11) **EP 1 274 125 A2**
(43) Date of publication of application: **08.01.2003**
(21) Application number: 02254289.8
(22) Date of filing: 20.06.2002
(51) Int. Cl.: H01L 23/498, H01L 23/66

(54) **Circuit board, method for manufacturing same, and high-output module**

(30) Priority: 05.07.2001 JP 2001204458
(71) Applicant: SUMITOMO ELECTRIC INDUSTRIES, LTD., Osaka-shi, Osaka (JP)
(72) Inventor: Tatoh, Nobuyoshi, c/o Itami Works, Itami-shi, Hyogo (JP); Nakanishi, Hidenori, c/o Itami Works, Itami-shi, Hyogo (JP)
(74) Representative: Cross, Rupert Edward Blount

(57) **Abstract**

A circuit board comprising a first metal layer 14 formed in patterns on a ceramic substrate 11, and a second metal layer 16 formed in patterns at least 0.5 µm thick on the first metal layer, wherein the first metal layer is reduced in width by etching. Also, a third metal layer 13 may be formed in patterns on the same plane as the first metal layer. The outermost surface of the second metal layer 16 is a metal such as gold that will not be etched. The circuit board has a fine and high-resolution wiring pattern and makes it possible to realize a miniature high-performance high-output module by mounting at least one high-output semiconductor element thereon.

## Description

The present invention relates to a semiconductor circuit board utilizing a ceramic, and to a method for manufacturing this circuit board, and to a high-output module.

Semiconductor elements include LD (laser diode or semiconductor laser), APD (avalanche photodiode), and other such optical semiconductor elements; HEMT (high electron mobility transistor), HBT (hetero-bipolar transistor), and other such semiconductor elements using GaAs, InP, Si/SiGe, or the like that can operate at high speed; IGBT (insulated gate bipolar transistor) and other such inverter/power converter silicon devices; and BiTe and other such thermoelectric semiconductor elements, and the circuit boards used in these fields need to have low electrical resistance, good thermal radiation, well-matched thermal expansion, and a super-fine wiring pattern for higher integration and speed.

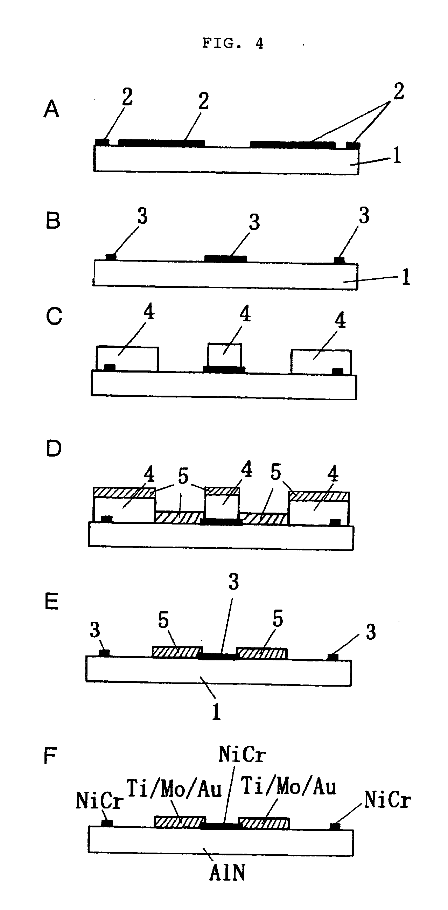

A conventional circuit board will be described through reference to Figs. 4A to 4E. As shown in Figs. 4A to 4E, the process has been as follows up to now. A metal mask or photomask 2 is applied on a ceramic substrate 1 (Fig. 4A), a third metal layer 3 is formed by vapor deposition or sputtering, and the metal mask or photomask 2 is removed (Fig. 4B), after which a resist 4 is formed (Fig. 4C), and then a first metal layer 5 is formed by vapor deposition or sputtering(Fig. 4D), and the resist is removed to obtain a completed product(Fig. 4E).

The ceramic substrate 1 is made from AlN or alumina. This is disclosed, for instance, in Japanese Patent Publication 2-271585. The third metal layer is used for a resistance, and is generally made from TaN, NiCr, or tungsten. The first metal layer is used for a wiring or an inductance, and has a multilayer structure comprising Ti/Mo/Au, Ti/Pt/Au, Cr/Mo/Au, or Ti/V/Au. The reason for using titanium or chromium for the layer in contact with the ceramic substrate is to increase the adhesion strength to the substrate. Because the platinum, molybdenum, or vanadium in the middle has a high melting point, it is inserted in order to prevent the top layer from alloying with the metal in the titanium or chromium in the portion in contact with the substrate. Gold is used for the top layer, and is selected in order to successfully perform wire bonding or die bonding. An example of the combination of materials in the completed product is shown in (Fig. 4F).

With a substrate for a power semiconductor, copper or gold is applied to the entire top surface of a ceramic substrate by vapor deposition, plating, or fusion, after which a wiring pattern is formed by etching.

To produce a high-output module, semiconductor elements are mounted on these circuit boards by means of die-bonding.

With today's high-output modules, in addition to making the modules smaller merely to reduce the size of the final apparatus, there is also the need to make the wiring patterns much finer with a reduced size so that higher frequencies can be handled. It is also necessary to minimize the resistance of the metallized portion formed for wiring in order to reduce loss of high frequency characteristics and decrease power consumption, and to this end thick-film techniques have become necessary to increase the thickness of the wiring pattern.

Both of these requirements could not be satisfied at the same time with a conventional circuit board. This is because a fine pattern could not be formed on a substrate, onto which a thick film resist has been applied, with a vapor deposition process relying on a metal mask or photomask, which is a conventionally practiced fine wiring process, and because vapor deposition had to be continued for a long time in order to obtain a thick film, so practical application was difficult. Also, when a wiring pattern was formed by etching, it was difficult to perform fine processing of a pattern smaller than the wiring thickness because side etching occurred, and etching removal was particularly difficult. Consequently, a miniaturized high-performance high-output module could not be realized.

It is an object here to provide a circuit board having thick-film fine wiring patterns, and to realize a miniature high-performance high-output module.

The present invention comprises the following constitutions (1) to (9).
(1) A circuit board comprising a first metal layer formed in patterns on a ceramic substrate, and a second metal layer at least 0.5 µm thick formed in patterns on the first metal layer, wherein the first metal layer is reduced in width by etching.
(2) The circuit board according to (1) above having a third metal layer formed in patterns on the same plane as the first metal layer.
(3) The circuit board according to (1) or (2) above, wherein the outermost layer of the second metal layer is gold.
(4) The circuit board according to (2) above, wherein the third metal layer is an alloy containing chromium or NiCr.
(5) The circuit board according to any of (1) to (4) above, wherein the ceramic substrate contains at least one selected from the group consisting of AlN and Si₃N₄ in an amount of at least 90 wt%.
(6) The circuit board according to any of (1) to (4) above, wherein the ceramic substrate is diamond or cBN.
(7) A method for manufacturing a circuit board comprising:
   vapor depositing or sputtering a first metal layer on a ceramic substrate;
   forming a resist with a thickness of at least 0.5 µm in patterns;
   applying a second metal layer on the first metal layer by plating using the resist as a mask; and
   removing the resist and then etching the first metal layer, using the second metal layer as a mask, whereby the first metal layer is reduced in width by etching.
(8) A method for manufacturing a circuit board comprising:
   forming a third metal layer in patterns on a ceramic substrate and then vapor depositing or sputtering a first metal layer;
   forming a resist with a thickness of at least 0.5 µm in patterns;
   applying a second metal layer on the first metal layer by plating using the resist as a mask; and
   removing the resist and then etching the first metal layer, using the second metal layer as a mask, whereby the first metal layer is reduced in width by etching.
(9) A high-output module, wherein at least one high-output semiconductor element that generates a heat of at least 10 mW is joined on the circuit board according to any of (1) to (6) above via a solder or an electrically conductive resin.

Fig. 1 is a cross section illustrating an example of the layer constitution of the metal layers of the circuit board according to the present invention.

Figs. 2A - 2G are diagrams illustrating the steps for manufacturing a circuit board in an example of the present invention.

Fig. 3 is a diagram of the structure of the high-output module produced in an example.

Figs. 4A - 4E are diagrams illustrating the steps for manufacturing a conventional circuit board and Fig. 4F is a diagram showing a combination of materials in the completed circuit board.

In the present invention, a multilayer structure composed, for example, of Ti/Mo/Ni, Ti/Pt/Ni, Ti/V/Ni, or Ti/Pd/Ni is used as the first metal layer. The thickness of the first metal layer is preferably 0.12 to 1.2 µm. If this layer is too thin, it will be difficult to achieve uniform metallization on the entire top surface of substrate, but if it is too thick, there will be so much side etching that fine working will be difficult. Keeping the thickness of the first metal layer to 0.4 µm or less substantially eliminates the effect of side etching. When the first metal layer is constituted of Ti/Mo/Ni, the thickness of the titanium should be 0.01 to 0.3 µm, the thickness of the molybdenum should be 0.01 to 0.3 µm, and the thickness of the nickel should be 0.1 to 0.6 µm.

The second metal layer can be constituted of gold, Ni/Au, silver, Pd/Au, Pt/Au, or V/Au, with gold being particularly favorable. When the second metal layer has a multilayer structure, the outermost layer should be gold. The thickness of the second metal layer is at least 0.5 µm. Keeping the thickness to at least 0.5 µm lowers the resistance of the wiring, reduces power consumption, and decreases loss of high frequency characteristics. Also, when the second metal layer has a multilayer structure, it is preferable for the outermost layer to cover the majority of the second metal layer, and it is particularly favorable if at least 80% of the side surface is covered by the outermost layer. If the outermost layer covers nearly all of the second metal layer and is a metal that will not be etched by the etching solution used for the first metal layer, the effect of side etching can be minimized during the etching of the first metal layer.

In order to form this second metal layer, a photoresist pattern is first formed on the above-mentioned first metal layer using a photomask. In this state the entire surface of the substrate can serve as an electrode, so a second metal layer can be selectively formed in a thick film by electroplating in the places where there is no photoresist. The resist is removed at this point. The first metal layer is then removed by etching, and this etching will be selective if the outermost layer of the second metal layer is a metal that will not be etched by the etching solution used for the first metal layer. For instance, if the first metal layer is Ti/Mo/Ni and the second metal layer is Ni/Au, the gold will not be etched by the etching solution for nickel and molybdenum, so the gold can be used as a mask in this etching. Titanium will only dissolve in a separate hydrofluoric acid-based etching solution, but since the gold will not be etched even by this etching solution, it can function as a mask for selective etching.

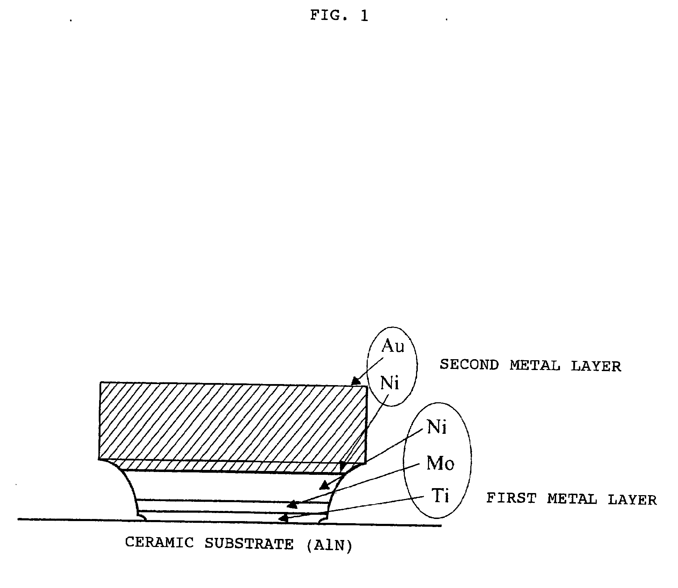

Fig. 1 illustrates an example of the layer structure of the metal layers in the circuit board obtained in this manner. The side surface below the gold of the second metal layer has been smoothly scooped out by side etching, and the scooping out of the titanium is even greater.

If a chromium-based (such as NiCr) metallization pattern is applied as a third metal layer at the outset for positioning the photomask or as a resistor, it will not be etched by any of the above-mentioned etching solutions, and will therefore remain until the end.

With the present invention, the second metal layer can be formed by electroplating, so a thick film of at least 0.5 µm can be obtained.

Also, since the second metal layer is formed utilizing the masking action of the resist with the present invention, the finesse and geometric accuracy of the first metal layer pattern is determined by how to form the photoresist for the second metal layer, and since the photoresist does not need multiple exposure, so the lowering of the geometric accuracy due to misalignment can be ignored. The thickness of the resist formed on the first metal layer should be at least 0.5 µm, since the thickness of the second metal layer is at least 0.5 µm. If the resist is too thin, the second metal layer will cover the top of the resist, resulting in an undesirable mushroom shape.
Furthermore, adjacent lines in the second metal layer will connect to each other on the resist. It was difficult to increase the thickness of the resist, but a thick film resist was achieved by optimizing the exposure conditions, which made it possible to form a fine wiring pattern with straight upright sides. An SOR (synchrotron orbital radiation) light was used for the exposure.

The pattern precision of the photoresist used for electroplating is on the submicron level, and the tiny spacing portions between photoresist lines can be plated by using a surfactant.

As the ceramic substrate, alumina may be used, but since thermal radiation is important with a high-output module, it is preferable to use diamond or cBN, or a material comprising AlN and/or Si₃N₄ in an amount of at least 90 wt%. AlN is the substrate with the lowest cost and high leak resistance. When strength is required, the use of Si₃N₄ is preferred. A mixture of AlN and Si₃N₄ may also be used. Also, if the substrate surface is too rough, disconnection may occur depending on the thickness of the laminated first metal layer, so surface-treating may be performed.

The present invention is also a high-output module comprising at least one high-output semiconductor element that generates a heat of at least 10 mW, joined on the circuit board obtained above via a solder or an electrically conductive resin.

Examples of the present invention will now be described through reference to the drawings.

### Example 1

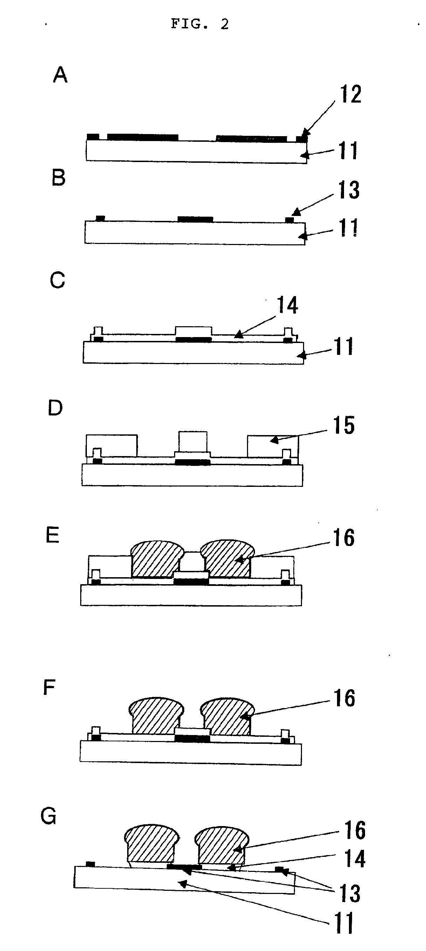

In Fig. 2A, a ceramic with an AlN content of at least 90 wt% was used as a ceramic substrate 11. This substrate contained yttrium, and it had good thermal radiation, with a thermal conductivity was 170 W/(m·K). The surface of the ceramic substrate was surface-treated to a surface roughness Ra of less than 0.8 µm. This is because the subsequently laminated first metal layer was 0.5 µm or less in thickness, so disconnection could occur if the surface were too rough.

A metal mask 12 was applied to the ceramic substrate 11, and an NiCr metal layer (the third metal layer) was formed. A sputtering apparatus was used for this purpose. This layer was used as a resistor or as a positioning mark during subsequent dicing of the substrate, and NiCr was selected here for use as a resistor. Fig. 2B illustrates the state when the metal mask 12 has been removed, after which an NiCr pattern as a third metal layer 13 has been formed on the surface of the ceramic substrate 11. Next, as shown in Fig. 2C, Ti/Mo/Ni was vapor deposited on as a first metal layer 14 on the entire top surface of the ceramic substrate 11. The thickness of the titanium was 0.05 µm, the thickness of the molybdenum was 0.05 µm, and the thickness of the nickel was 0.3 µm.

On this, a resist 15 was formed using a photomask, as shown in Fig. 2D. The thickness of the resist 15, taking into consideration the thickness of the second metal layer, was 2 µm.

Next, in the step shown in Fig. 2E, Ni/Au was laminated as a second metal layer 16 by electroplating. To improve the adhesion of the plating, the nickel thickness was 0.5 µm, and the gold thickness was 3 µm. Because of the thickness of the resist 15, the second metal layer 16 was somewhat mushroom-shaped, but not enough to pose a problem. This metal layer may be gold alone if an alloying treatment is subsequently performed to raise the adhesive strength.

The resist 15 was removed as shown in Fig. 2F, after which the nickel and molybdenum of the first metal layer 14 were etched. Here, nickel oxide was formed on the surface during the resist removal, so this was removed, after which the nickel and molybdenum were etched all at once with a reactive etching solution. The titanium was removed with a hydrofluoric acid-based etching solution. The thus completed product is shown in Fig. 2G.

The resistance between wiring lines was at least 1 MΩ, and the resulting circuit board also had excellent insulation.

The metal layers were formed on one side of the ceramic substrate in the above example, but can also be applied to both sides at the same time.

### Example 2

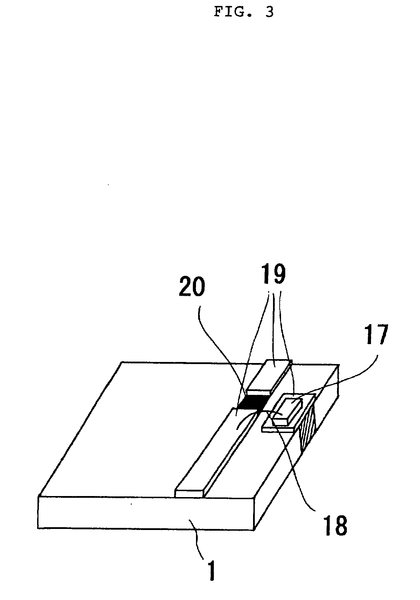

A circuit board having the pattern shown in Fig. 3 was produced using the process described above in Example 1. The wiring layer 19 here was such that the first metal layer was Ti/Mo/Ni and the second metal layer was Ni/Au, and the third metal layer used as the resistor layer 20 was Ni/Cr. As shown in Fig. 3, a high-output LD (semiconductor laser) 17 with an integrated modulator and a heat generation of at least 10 mW was die bonded with solder to this circuit board, and wire bonding was performed using a bonding wire 18. After mounting the LD, the module was operated, whereupon the SN ratio of modulation characteristics was 0.1 dB better than when a conventional circuit board was used. The size of the circuit board for mounting the LD was only one-fourth that of a conventional board, and the speed limit was increased to 40 Gbps or more.

The present invention makes it possible to obtain a miniature high-performance circuit board having thick-film fine wiring patterns. It is therefore possible to obtain a miniature high-performance high-output module.

## Claims

1. A circuit board comprising a first metal layer formed in patterns on a ceramic substrate, and a second metal layer at least 0.5 µm thick formed in patterns on the first metal layer, wherein the first metal layer is reduced in width by etching.

2. The circuit board according to Claim 1 having a third metal layer formed in patterns on the same plane as the first metal layer.

3. The circuit board according to Claim 1 or 2, wherein the outermost layer of the second metal layer is gold.

4. The circuit board according to Claim 2, wherein the third metal layer is an alloy containing chromium or NiCr.

5. The circuit board according to any of Claims 1 to 4, wherein the ceramic substrate contains at least one selected from the group consisting of AlN and Si₃N₄ in an amount of at least 90 wt%.

6. The circuit board according to any of Claims 1 to 4, wherein the ceramic substrate is diamond or cBN.

7. A method for manufacturing a circuit board comprising:
vapor depositing or sputtering a first metal layer on a ceramic substrate;
forming a resist with a thickness of at least 0.5 µm in patterns;
applying a second metal layer on the first metal layer by plating using the resist as a mask; and
removing the resist and then etching the first metal layer, using the second metal layer as a mask, whereby the first metal layer is reduced in width by etching.

8. A method for manufacturing a circuit board comprising:
forming a third metal layer in patterns on a ceramic substrate and then vapor depositing or sputtering a first metal layer;
forming a resist with a thickness of at least 0.5 µm in patterns;
applying a second metal layer on the first metal layer by plating using the resist as a mask; and
removing the resist and then etching the first metal layer, using the second metal layer as a mask whereby the first metal layer is reduced in width by etching.

9. A high-output module, wherein at least one high-output semiconductor element that generates a heat of at least 10 mW is joined on the circuit board according to any of Claims 1 to 6 via a solder or an electrically conductive resin.
